# EUROPÄISCHE PATENTSCHRIFT

(11) **EP 3 346 549 B1**
(45) Veröffentlichungstag und Bekanntmachung des Hinweises auf die Patenterteilung: **24.02.2021**
(21) Anmeldenummer: 18150257.6
(22) Anmeldetag: 04.01.2018
(51) Int. Cl.: H01Q 1/22, H01Q 15/00

(54) **ELEKTRONISCHES MODUL MIT INTEGRIERTER ANTENNE UND VERFAHREN ZUR HERSTELLUNG**
ELECTRONIC MODULE WITH INTEGRATED ANTENNA AND METHOD OF MAKING SAME
MODULE ÉLECTRONIQUE POURVU D'ANTENNE INTÉGRÉE ET PROCÉDÉ DE FABRICATION

(30) Priorität: 05.01.2017 DE 102017200128
(43) Veröffentlichungstag der Anmeldung: 11.07.2018
(73) Patentinhaber: Fraunhofer-Gesellschaft zur Förderung der angewandten Forschung e.V., 80686 München (DE)
(72) Erfinder: NDIP, Ivan, 13469 Berlin (DE); OSTMANN, Andreas, 10585 Berlin (DE)
(74) Vertreter: Hersina, Günter

(56) Entgegenhaltungen:
- DE-A1-102006 023 123
- US-A1- 2008 029 886
- US-A1- 2009 251 357
- US-B1- 7 522 105
- US-B2- 7 372 408
- US-B2- 8 407 890

## Beschreibung

Die Erfindung bezieht sich auf ein elektronisches Modul sowie auf ein Verfahren zur Herstellung eines elektronisches Moduls.

Leiterplattenanordnungen, auf denen elektronische Komponenten aufgebracht sind, sind in vielen Bereichen der Technik bekannt und in Anwendung. Relevante und kritische Themenbereiche bei solchen Leiterplattenanordnungen sind beispielsweise die elektrische Verbindung zwischen den Komponenten, die Kontaktierung der Komponenten von außen oder die Reduktion des Platzbedarfs der Komponenten und damit auch eine Verkleinerung der Anordnung an sich. Ziel ist es oft, die Integrationsdichte zu erhöhen.

Die Leiterplatten (andere Bezeichnungen sind Platine, Leiterkarte oder gedruckte Schaltung, englisch printed circuit board, PCB) bestehen im Allgemeinen aus elektrisch isolierendem Material und weisen auf ihren (Ober- bzw. Unter-)Seiten elektrisch leitende Verbindungen in Form von Leiterbahnen auf.

Es sind dabei Anordnungen mit einer Leiterplatte oder mit mehreren übereinander angeordneten Leiterplatten (sog. Multilayer-Leiterplatten) bekannt. Für die Herstellung der Leiterplatten sind teilweise sog. PrePregs in Verwendung. Dabei handelt es sich um mit Harzen vorimprägnierte textile Faser-Matrix-Halbzeuge, die unter Druck und Temperatur aushärten.

Im Stand der Technik ist es bekannt, Komponenten oder beispielsweise Chips in die Leiterplatten einzubetten (englisch embedding). Unterschieden werden beispielsweise zwei grundlegende Verfahren, die sich darin voneinander unterscheiden, ob die Kontakte bzw. Pins der Komponenten entweder der Leiterplatte (sog. Face-Down-Embedding) oder von der Leiterplatte weggewandet sind (sog. Face-Up-Embedding). Dabei sind die Komponenten insbesondere im Material der Leiterplatte eingebunden (siehe z. B. DE 199 54 941 A1, DE 10 2005 032 489 B3 oder DE 694 30 765 T2). Dabei handelt es sich bei den Leiterplattenanordnungen mit eingebundenen Komponenten teilweise um elektronische Komponenten. Bei vielen Anwendungen ist es vorteilhaft, wenn die elektronischen Komponenten auch über integrierte Antennen verfügen.

Die US 2009/251357 A1 beschreibt eine Dualbandantenne mit aufgesetztem Chip. Die US 2008/0029886 A1 beschreibt eine Antenne, bei der Chip und Antennenelement in dasselbe Substrat eingebettet sind.

DE 10 2006 023123 A1 und US 8 407 890 B2 beschreiben jeweils ein Halbleitermodul, wobei Durchkontaktierungen zwischen einer integrierten Antenne in einem ersten Substrat und einem Chip in einem zweiten Substrat angeordnet sind.

US 7 372 408 B2 beschreibt ein elektronisches Modul mit zwei Substraten in welchen eine Antenne im ersten Substrat und eine elektronische Komponente im zweiten Substrat nebeneinander angeordnet sind und eine leitende, die Antenne umlaufende, vertikale Wand im zweiten Substrat zur Abschirmung von elektrischer Strahlung vorhanden ist.

Die Aufgabe der Erfindung besteht darin, ein elektronisches Modul vorzugsweise mit eingebetteten Komponenten und mindestens einer integrierten Antenne sowie ein Verfahren zur Herstellung eines solchen Moduls vorzuschlagen.

Die Erfindung löst die Aufgabe durch ein elektronisches Modul und durch ein Verfahren zur Herstellung eines elektronischen Moduls.

Das erfindungsgemäße elektronische Modul weist ein erstes Substrat und ein zweites Substrat auf. Dabei trägt das erste Substrat eine integrierte Antennenvorrichtung und ist das erste Substrat mit dem zweiten Substrat verbunden. Das erste Substrat und das zweite Substrat bilden damit auch eine Leiterplattenanordnung. In einer Ausgestaltung sind zudem elektronische Komponenten in der Leiterplattenanordnung bzw. in dem ersten Substrat und/oder dem zweiten Substrat eingebettet.

Das erfindungsgemäße elektronische Modul verfügt somit über zwei getrennte, eigenständige Substrate. Ein Substrat trägt die integrierte Antennenvorrichtung. Die beiden Substrate sind miteinander verbunden, so dass sich insgesamt eine elektronisches Modul ergibt. Das Modul weist in einer Ausgestaltung mehrere Substrate auf.

Dabei befindet sich zumindest die für die Abstrahlung der Signale aktive Fläche der integrierten Antennenvorrichtung zwischen dem ersten und dem zweiten Substrat.

Die integrierte Antennenvorrichtung weist je nach Ausgestaltung beispielweise mindestens eine Patchantenne, eine Grid Array-Antenne oder eine Schlitzantenne auf. Alternativ weist sie mindestens eine Antenne mit einem Wellenleiter auf, der zumindest teilweise durch das erste Substrat gebildet wird. In anderen Ausgestaltungen sind Dipol-, Monopol-, Yagi-Uda- oder Vivaldi-Antennen beispielsweise vorgesehen. In alternativen oder ergänzenden Ausgestaltungen sind smarte, rekonfigurierbare und/oder kleine Antennen (sog. electrically small antenna, die sehr klein gegenüber ihrer Radiansphere gemäß der Definition von H. A. Wheeler sind) vorgesehen. In einzelnen Ausgestaltungen ist vorgesehen, dass unterschiedliche Antennenkonfigurationen je nach Art der Anwendung entweder als einzelne Elemente oder als Gruppenstrahler (also als ein aus mehreren einzelnen Antennen bestehendes Array) benutzbar sind. In einer Ausgestaltung besteht die Antennenvorrichtung aus einer Kombination aus mehreren Antennenkonfigurationen.

Je nach Ausgestaltung strahlt die integrierte Antennenvorrichtung z. B. nur in der azimutalen Ebene, nur in der vertikalen Ebene oder in beiden Ebenen gleichzeitig. Dies jeweils bezogen auf die Ebene, in der sich die integrierte Antennenvorrichtung befindet.

Das elektronische Modul ist in einer Ausgestaltung ein Modul, das für eine weitere Verarbeitung bzw. einen Einbau in eine größere Einheit vorgesehen ist.

Die Antennenschicht und das erste Substrat sind in einer Ausgestaltung ein separat gefertigtes Fertigungselement, das auf einem ebenfalls separat gefertigten zweiten Substrat, in dem die Bauteile, Chips und sonstigen elektronischen Komponenten integriert sind, aufgebracht und befestigt wird.

In einer Ausgestaltung sind unterhalb des ersten Substrats - und damit unterhalb der von dem zweiten Substrat abgewandten Seite des ersten Substrats - weitere Substrate vorhanden. Hiermit wird ein Multilayer erzeugt.

Erfindungsgemäß weist das elektronische Modul elektronische Komponenten (z. B. Chips, passive oder aktive Bauteile usw.) auf, die zumindest in einem Substrat eingebettet sind. Dabei handelt es sich vorzugweise um Bauteile, die der Realisierung des elektrischen Systems bzw. des Moduls dienen. In einer Ausgestaltung erlauben die Komponenten die Realisierung einer rekonfigurierbaren, einer adaptiven oder smarten Antennenvorrichtung oder allgemein eines Mehrantennensystems.

Erfindungsgemäß ist zwischen der integrierten Antennenvorrichtung und mindestens einer eingebetteten Komponente mindestens eine Abschirmvorrichtung vorhanden. Die Abschirmvorrichtung (z. B. Vias oder Metalllagen) schirmt dabei die eingebetteten Komponenten vor den Feldern der Antennenvorrichtung ab.

Die integrierte Antennenvorrichtung ist dabei derartig ausgestaltet, dass sie lateral oder vertikal oder lateral und vertikal elektromagnetische Signale abstrahlt.

Erfindungsgemäß ist vorgesehen, dass das erste Substrat auf einer Seite des zweiten Substrats aufliegt. Erfindungsgemäß liegt das erste Substrat mit einer Seite auf dem zweiten Substrat auf, so dass beide gleichsam als Schichten übereinander liegen. In diesen Ausgestaltungen sind somit insbesondere keine Seitenflächen der Substrate miteinander verbunden, sondern die Ober- bzw. Unterseite der Substrate.

In einer Ausgestaltung haben das erste Substrat und das zweite Substrat im Wesentlichen die gleichen Ausdehnungen der Seiten. Die beiden Substrate haben somit in dieser Ausgestaltung im Wesentlichen die gleichen Maße in Bezug auf Breite und Länge oder alternativ in Bezug auf den Durchmesser.

Erfindungsgemäß trägt das zweite Substrat elektronische Komponenten Dabei handelt es sich beispielsweise um mindestens einen Chip und/oder mindestens ein elektronisches Bauteil. Der Chip erzeugt beispielsweise RF-Signale. Die Komponenten des zweiten Substrats (also insbesondere Chip und/oder elektronisches Bauteil) sind in einer Ausgestaltung zumindest teilweise oder vollständig in dem zweiten Substrat eingebettet. In einer Ausgestaltung sind die Komponenten, die Wärme erzeugen, vorzugsweise unmittelbar mit einem Kühlkörper verbunden, der die Wärme abführt bzw. verteilt.

Eine Ausgestaltung beinhaltet, dass die integrierte Antennenvorrichtung und die elektronischen Komponenten und/oder die elektronischen Komponenten untereinander über Verbindungsstrukturen zur Übertragung von elektrischen Signalen und/oder elektrischer Energie miteinander verbunden sind. Weiterhin sind die Verbindungsstrukturen innerhalb des elektronischen Moduls (bzw. mit anderen Worten: innerhalb der Leiterplattenanordnung als Teil des elektronischen Moduls) angeordnet. In einer Ausgestaltung befinden sich die Verbindungsstrukturen, die z. B. aus Leitungen, Kontakten, Drähten usw. bestehen, im ersten und/oder im zweiten Substrat. Weitere Kontaktanschlüsse sind vorzugsweise auf einer Seite des ersten Substrats zusammengeführt und erlauben die Kontaktierung mit weiteren - externen - Einheiten und Komponenten.

Gemäß einer Ausgestaltung ist das erste Substrat bis auf die integrierte Antennenvorrichtung frei von elektronischen Komponenten. In dieser Ausgestaltung befindet sich insbesondere kein Chip und kein elektronisches Bauteil - als Beispiele für Komponenten - auf oder in dem ersten Substrat.

In einer Ausgestaltung sind Kontakte der integrierte Antennenvorrichtung - vorzugsweise nur - auf einer Seite des ersten Substrats angeordnet, die einer Seite gegenüberliegt, auf der sich die integrierte Antennenvorrichtung im Wesentlichen oder hauptsächlich befindet. Die in Bezug auf das Senden und/oder Empfangen von elektromagnetischen Signalen relevante Wirkfläche der integrierte Antennenvorrichtung befindet sich somit auf einer Seite des ersten Substrats und die Kontakte zum Ansteuern der integrierte Antennenvorrichtung bzw. zum Abgreifen von Signalen befinden sich auf der gegenüberliegenden Seite des ersten Substrats. Die Seite, auf der sich die integrierte Antennenvorrichtung hauptsächlich befindet, ist in einer Ausgestaltung dem zweiten Substrat zugewandt und bildet damit auch die Seite, mit der das erste Substrat auf dem zweiten Substrat aufliegt. Das erste Substrat wird somit gemäß dem Face-Down-Embedding mit dem zweiten Substrat verbunden. In einer alternativen Ausgestaltung wird das erste Substrat gemäß dem Face-Up-Embedding, also mit der die Kontakte tragenden Seite, auf dem zweiten Substrat aufgebracht. Die Kontakte dienen allgemein der Verbindung der integrierte Antennenvorrichtung zu weiteren Komponenten oder Einheiten vorzugsweise außerhalb der Leiterplattenvorrichtung.

Bei einer Ausgestaltung ist die integrierte Antennenvorrichtung derartig auf und/oder in dem ersten Substrat aufgebracht und ist das erste Substrat derartig relativ zu dem zweiten Substrat angeordnet, dass eine Hauptabstrahlrichtung der integrierten Antennenvorrichtung dem zweiten Substrat zugewandt ist. In dieser Ausgestaltung strahlt die integrierte Antennenvorrichtung hauptsächlich in Richtung des zweiten Substrats elektromagnetische Signale aus. In einer Ausgestaltung befindet sich die integrierte Antennenvorrichtung auf einer (Ober- oder Unter-)Seite des ersten Substrats. Dabei ist die integrierte Antennenvorrichtung dem zweiten Substrat zugewandt und liegt damit auch auf dem zweiten Substrat auf.

Erfindungsgemäß ist vorgesehen, dass in dem zweiten Substrat mindestens eine Durchkontaktierung zwischen einer Komponente und einem in der Hauptabstrahlrichtung der integrierten Antennenvorrichtung liegenden Bereich vorhanden ist. Die Durchkontaktierung (oder sog. "Via") stellt somit einen seitlichen Schutz für die Komponenten des zweiten Substrats dar. Hierfür befindet sich die Durchkontaktierung zwischen der Komponente und dem Bereich des zweiten Substrats, der von der integrierten Antennenvorrichtung hauptsächlich mit elektromagnetischen Signalen durchstrahlt wird.

Eine Ausgestaltung besteht darin, dass die integrierte Antennenvorrichtung derartig auf und/oder in dem ersten Substrat aufgebracht ist und das erste Substrat derartig relativ zu dem zweiten Substrat angeordnet ist, dass das zweite Substrat oberhalb der integrierten Antennenvorrichtung im Wesentlichen frei von abschirmenden Komponenten ist. In dieser Ausgestaltung befindet sich in dem zweiten Substrat oberhalb der integrierten Antennenvorrichtung im Wesentlichen nur das Material des Grundkörpers des Substrats, also beispielsweise ein Dielektrikum. Vorzugsweise sind auch keine sonstigen abschirmenden Strukturen oder Elemente oberhalb der integrierten Antennenvorrichtung vorhanden. Die elektronischen Komponenten sind insoweit abschirmend, als dass sie sich auf die ausgestrahlten Signale auswirken würden, wenn sie in der Abstrahlrichtung befindlich wären. Es handelt sich somit beispielsweise um Chips oder andere aktive oder passive Bauteile. Diese Ausgestaltung erlaubt es, dass die integrierte Antennenvorrichtung weitgehend ungehindert elektromagnetische Signale - insbesondere in Verbindung mit der vorgenannten Ausgestaltung - in Richtung des zweiten Substrats ausstrahlt.

Erfindungsgemäß ist vorgesehen, dass das erste Substrat und/oder das zweite Substrat Abschirmvorrichtungen aufweist/aufweisen. Die Abschirmvorrichtungen sind dabei vorzugsweise als "via fences" bzw. "via shielding" (also allgemein Durchkontaktierungen) ausgestaltet, so dass sie gegenüber elektromagnetischen Wellen einen Schutz darstellen. Der Schutz besteht dabei vorzugsweise für Komponenten des elektronischen Moduls gegenüber den elektromagnetischen Signalen der integrierte Antennenvorrichtung.

In einer Ausgestaltung verfügt das erste Substrat im Bereich der integrierten Antennenvorrichtung über Löcher, die eine photonische Bandlückenstruktur (englisch "photonic bandgap structure") bilden, um Oberflächenwellen zu filtern. Alternativ oder ergänzend reduzieren die Löcher die Permittivität des ersten Substrats. Die Ausgestaltungen erlauben es, größer dimensionierte Antennenstrukturen im Millimeterwellen- oder Terahertz-Bereich zu verwenden. Die größeren Abmessungen reduzieren dabei auch die Auswirkungen von Fertigungstoleranzen.

Alternativ oder ergänzend sind elektromagnetische Bandlückenstrukturen im ersten Substrat vorhanden.

Die folgenden Ausgestaltungen zeigen, dass die beiden getrennten Substrate es erlauben, jeweils passend für die Funktion des Substrats (also Tragen der integrierte Antennenvorrichtung bzw. Tragen des anderen Substrats und Tragen von weiteren Komponenten und/oder Bauteilen) das Substrat in Bezug auf seine Eigenschaften zu wählen bzw. auszugestalten.

Eine Ausgestaltung besteht darin, dass das erste Substrat und das zweite Substrat zumindest teilweise aus unterschiedlichen Materialien bestehen.

Das erste Substrat besteht beispielsweise aus einem Polymer, aus einem für Hochfrequenz geeigneten Laminat, aus einem Glas oder einem Dielektrikum.

Eine Ausgestaltung sieht vor, dass das erste Substrat und das zweite Substrat unterschiedliche Dicken (bzw. Höhen) aufweisen.

Gemäß einer Ausgestaltung ist mindestens ein - vorzugsweise mit einer elektronischen Komponente thermisch leitend kontaktiertes bzw. verbundenes - Kühlelement vorhanden. Die elektronische Komponente ist vorzugsweise eingebettet, wobei die vorgenannte Ausgestaltung die Abfuhr der erzeugten Wärme erlaubt.

Weiterhin löst die Erfindung die Aufgabe durch ein Verfahren zum Erzeugen eines elektronischen Moduls.

Das Verfahren umfasst dabei zumindest die folgenden Schritte:
- ein erstes Substrat wird mit einer integrierten Antennenvorrichtung erzeugt,
- das erste Substrat wird auf einem zweiten Substrat aufgebracht.

In einer Ausgestaltung werden unterhalb des zweiten Substrats und in einer Ausgestaltung insbesondere unterhalb des ersten Substrats weitere Substrate aufgebracht.

In einer Ausgestaltung wird die integrierte Antennenvorrichtung auf oder zumindest teilweise in dem ersten Substrat erzeugt und anschließend wird das erste Substrat auf dem zweiten Substrat aufgebracht. Die integrierte Antennenvorrichtung wird somit separat auf dem ersten Substrat erzeugt und erst das fertige erste Substrat wird auf das zweite Substrat aufgebracht und mit diesem verbunden.

In einer alternativen Ausgestaltung wird die integrierte Antennenvorrichtung auf dem ersten Substrat erzeugt, wobei das erste Substrat bereits auf dem zweiten Substrat aufgebracht worden ist.

Das Aufbringen des ersten Substrats auf das zweite Substrat umfasst in einer Ausgestaltung auch das Fixieren.

In einer Ausgestaltung des Verfahrens ist vorgesehen, dass zwischen der integrierten Antennenvorrichtung und Komponenten auf dem zweiten Substrat elektrische und/oder thermische Verbindungen erzeugt werden.

Erfindungsgemäß werden in das zweite Substrat und/oder in das erste Substrat und/oder in ein weiteres Substrat elektronische Komponenten eingebettet. Das zweite Substrat ist dabei - wie vorzugsweise auch das erste Substrat - eine Leiterplatte.

Gemäß einer Ausgestaltung wird innerhalb des elektronischen Moduls zwischen der integrierten Antennenvorrichtung und Komponenten und/oder zwischen Komponenten mindestens eine elektrische Verbindungsstruktur erzeugt. In einer Ausgestaltung verfügen die beiden Substrate über Leiterbahnen oder sonstige Kontaktelemente, die beim Verbinden zwischen den beiden Substraten entsprechend miteinander kontaktiert werden. Die Verbindungsstrukturen bestehen dabei innerhalb des elektronischen Moduls und somit beispielsweise zumindest teilweise zwischen den Substraten und/oder innerhalb beider Substrate. In einer Ausgestaltung erlaubt die Verbindungsstruktur die Verbindung zwischen den Komponenten und/oder zwischen mindestens einer Komponente und der integrierten Antennenvorrichtung.

Gemäß einer Ausgestaltung wird in einem Bereich des zweiten Substrats, der von der integrierte Antennenvorrichtung mit elektromagnetischen Signalen durchstrahlt wird, Material entfernt. Das zweite Substrat weist somit eine Lücke in dem Bereich auf, durch den die integrierte Antennenvorrichtung die elektromagnetischen Signale ausstrahlt.

In einer Ausgestaltung werden in dem ersten Substrat - das also die integrierte Antennenvorrichtung trägt - periodisch angeordnete durchgehende Löcher erzeugt. Dabei wird in einer Ausgestaltung durch die periodisch angeordneten durchgehenden Löcher eine photonische Bandlückenstruktur erzeugt.

Erfindungsgemäß wird zwischen der integrierten Antennenvorrichtung und mindestens einer elektronischen Komponente mindestens eine Abschirmvorrichtung erzeugt. Die Abschirmvorrichtung sind dabei beispielsweise Durchkontaktierungen oder als Metallisierung ausgeführte Substratschichten. In einer Ausgestaltung werden zwischen der integrierten Antennenvorrichtung und allen Komponenten Abschirmvorrichtungen zum Schutz vor den elektromagnetischen Feldern der integrierten Antennenvorrichtung erzeugt.

In einer Ausgestaltung wird mindestens eine elektronische Komponente mit einem Kühlelement verbunden. Dies dient der Abführung von Wärme.

In einer Ausgestaltung wird mindestens ein Teil des ersten Substrats mit periodischen Löcher versehen. Dies dient in einer Ausgestaltung dazu, Oberflächenwellen auszufiltern. In einer weiteren Ausgestaltung reduzieren die Löcher alternativ oder ergänzend die effektiven Perimittivität des ersten Substrats. Dies erlaubt es, Antennenvorrichtungen mit größeren Abmessungen zu realisieren. Dies hat den Vorteil, dass der Einfluss von Prozessschwankungen bei Millimeter-Wellen bzw. Terahertz Frequenzen geringer ist.

In einer Ausgestaltung wird die integrierte Antennenvorrichtung auf einer elektromagnetische Bandgap Struktur hergestellt. Das erste Substrat ist daher entsprechend auszugestalten.

In einer Ausgestaltung werden Rauschunterdrückungsstrukturen (z. B. EBG) verwendet, um unerwünschte Kopplungen zwischen eingebettete Komponenten bzw. zwischen den Komponenten und der integrierten Antennenvorrichtung zu unterdrücken.

Die obigen Ausgestaltungen des elektronischen Moduls lassen sich durch Schritte von entsprechenden Ausgestaltungen des Verfahrens realisieren, so dass hier auf eine Wiederholung der Ausführungen verzichtet sei. Umgekehrt führen die Ausgestaltungen des Verfahrens auch zu entsprechenden Ausgestaltungen des elektronischen Moduls, so dass die obigen Ausführungen auch für die Modul-Ausgestaltungen gelten.

Im Einzelnen gibt es eine Vielzahl von Möglichkeiten, das erfindungsgemäße elektronische Modul sowie das Verfahren auszugestalten und weiterzubilden. Dazu wird verwiesen einerseits auf die Patentansprüche, andererseits auf die folgende Beschreibung von Ausführungsbeispielen in Verbindung mit der Zeichnung. Es zeigen:
- Fig. 1: einen Schnitt durch eine schematische Darstellung einer ersten Ausgestaltung des erfindungsgemäßen elektronischen Moduls,
- Fig. 2: einen Schnitt durch eine schematische Darstellung einer zweiten Ausgestaltung des erfindungsgemäßen elektronischen Moduls und
- Fig. 3: einen Schnitt durch eine schematische Darstellung einer dritten Ausgestaltung des erfindungsgemäßen elektronischen Moduls

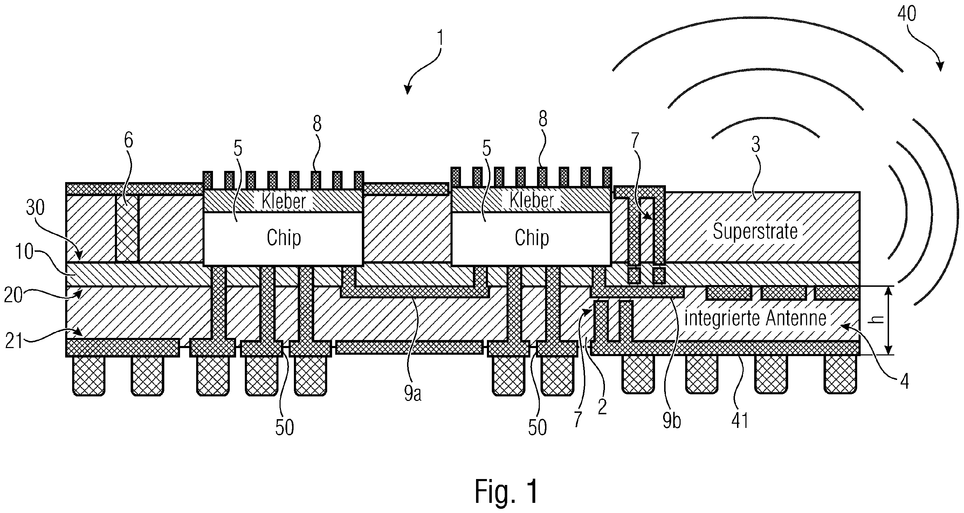

Das elektronische Modul 1 der Fig. 1 verfügt über ein erstes Substrat 2 und ein zweites Substrat 3, deren Seiten jeweils einander gegenüberliegen und die miteinander verbunden sind. Zwischen dem ersten Substrat 2 und dem zweiten Substrat 3 befindet sich eine dünne PrePreg-Lage 10. Gebildet wird damit insgesamt eine Leiterplattenanordnung.

Das erste Substrat 2 verfügt über eine integrierte Antennenvorrichtung 4, die somit in dem ersten Substrat 2 zumindest teilweise eingebettet ist. Die Seite 20 des ersten Substrats 2, auf der sich die integrierte Antennenvorrichtung 4 hauptsächlich befindet, ist dabei dem zweiten Substrat 3 zugewandt. Erfindungsgemäß ist eine Metallisierung als Reflektor 41 der integrierten Antennenvorrichtung 4 auf der gegenüberliegenden Seite 21 des ersten Substrats 2 aufgebracht. Auf dieser Seite 21 sind hier auch Ball Grid Array Lotkugeln vorhanden.

Die Seite 20 des ersten Substrats 2, das die integrierte Antennenvorrichtung 4 trägt, ist dabei mit einer Seite 30 des zweiten Substrats 3 verbunden. Deshalb lässt sich das zweite Substrat 3 in dem Bereich oberhalb der integrierten Antennenvorrichtung 4 somit auch als "Superstrate" bezeichnen.

Zu erkennen ist, dass die beiden Substrate 2, 3 deutlich unterschiedliche Höhen bzw. Dicken aufweisen. Beispielhaft ist die Höhe h des ersten Substrats 2 eingezeichnet. Daher kann insbesondere die Höhe des ersten Substrats 2 gezielt für die Eigenschaften der integrierten Antennenvorrichtung 4 gewählt bzw. eingestellt werden.

Das zweite Substrat 3 verfügt in der dargestellten beispielhaften Ausgestaltung über zwei Chips 5 (als Beispiel für integrierte Schaltungen) und ein elektronisches Bauteil 6, das hier beispielweise ein passives Bauteil (z. B. Widerstand, Spule, Kondensator) ist. Zu sehen ist, wie die Chips 5, die hier als Beispiel dienen, so angeordnet sind, dass ihre Kontakte 50 auch auf der Seite 21 des ersten Substrats 2 münden, die vom zweiten Substrat 3 abgewandt ist. Hierfür sind die Kontakte 50 der Chips 5 durch das erste Substrat 2 hindurchgeführt. Die Chips 5 und die Bauteile 6 sind somit Beispiele für die zusätzlich zu der Antennenvorrichtung 4 in dem elektronischen Modul 1 eingebetteten Komponenten.

Das zweite Substrat 3 ist oberhalb der integrierten Antennenvorrichtung 4 frei von Komponenten oder Strukturen, die das Ausbreiten der elektromagnetischen Signale 40 der integrierten Antennenvorrichtung 4 behindern könnten. Hierbei ist auch zu erkennen, dass die Hauptstrahlrichtung der integrierten Antennenvorrichtung 4 dem zweiten Substrat 3 zugewandt ist, so dass die integrierte Antennenvorrichtung 4 somit durch das zweite Substrat 3 hindurchstrahlt.

Dabei sei generell angemerkt, dass zwar nur der Fall diskutiert wird, dass die integrierte Antennenvorrichtung 4 elektromagnetische Signale 40 aussendet, gleichwohl gelten die Erläuterungen auch für den Fall des Empfangs von solchen Signalen.

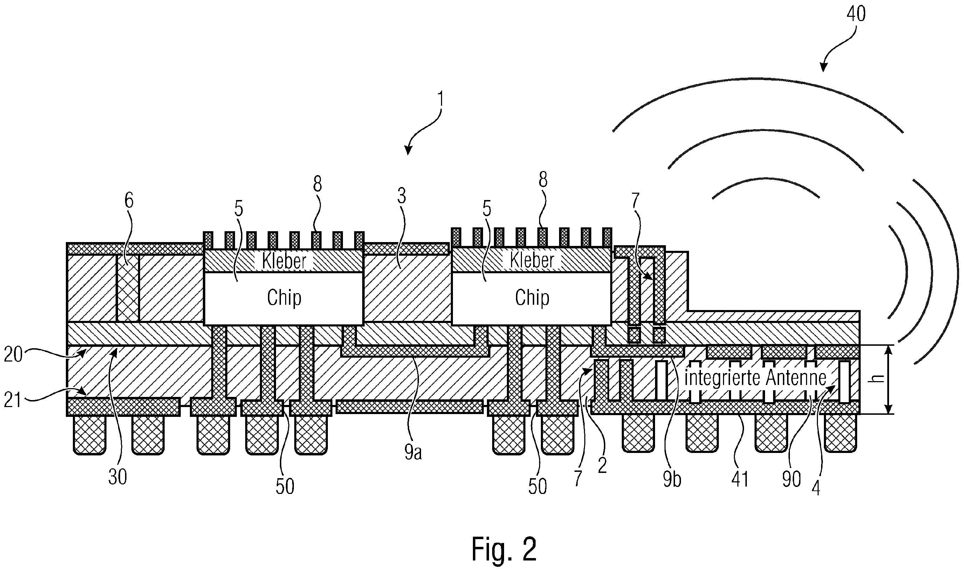

In der dargestellten Ausgestaltung verfügt das erste Substrat 2 nur über die integrierte Antennenvorrichtung 4 und keine weiteren Komponenten oder elektronischen Bauteile. Vorhanden sind lediglich elektrische Verbindungen oder sonstige Strukturbesonderheiten (z. B. die Löcher der Ausgestaltung der Fig. 2). In weiteren - hier nicht dargestellten Ausgestaltungen - sind im erste Substrat 2 weitere Komponenten (z. B. Chips, passive oder aktive Komponenten) eingebettet. Dabei handelt es sich in einer Ausgestaltung um Komponenten, die verwendet werden, um rekonfigurierbare Antennen (dabei handelt es sich bei den Komponenten z. B. um Schalter oder Pin Diode) oder Smart-Antennen (dies ist beispielhaft verbunden mit solchen Komponenten wie Phasenschiebern) zu realisieren. Alternativ oder ergänzend sind solche Komponenten in weiteren Ausgestaltung im ersten Substrat 2 oder im zweiten Substrat 3 eingebettet. In anderen Ausgestaltungen sind unterhalb des ersten Substrats 2, das die integrierte Antennenvorrichtung 4 trägt, weitere Substratlagen (Multilayer-Substraten) realisiert. Diese weiteren Substratlagen ermöglichen die Integration von weiteren Systemkomponenten.

In dem ersten Substrat 2 und dem zweiten Substrat 3 befinden sich Abschirmvorrichtungen 7, die die Komponenten 5, 6 des zweiten Substrats 3 vor der elektromagnetischen Strahlung der integrierten Antennenvorrichtung 4 schützen sollen. Zu beachten sind hier insbesondere die Durchkontaktierungen als Abschirmvorrichtungen 7, die sich in dem zweiten Substrat 3 befinden und die sich zwischen den Komponenten 5, 6 und dem Bereich des zweiten Substrats 3 befinden, der von der integrierten Antennenvorrichtung 4 mit elektromagnetischen Signalen beaufschlagt wird.

Zu erkennen sind weiterhin die elektrischen Verbindungsstrukturen 9b zwischen den Chips 5 - bzw. allgemein zwischen eingebetteten Komponenten 5, 6 - und der integrierten Antennenvorrichtung 4 und andererseits die elektronischen Verbindungsstrukturen 9a untereinander zwischen den Chips 5 bzw. zwischen den Komponenten 5, 6.

Auf der Oberseite der Chips 5 sind in dem gezeigten Beispiel Kühlelemente 8 z. B. mit einem Kleber befestigt, die Wärme abführen bzw. verteilen.

Das elektronische Modul 1 der Ausgestaltung der Fig. 2 unterscheidet sich von der Ausgestaltung der Fig. 1 in der Ausführung des Bereichs des ersten Substrats 2 in der Nähe der integrierten Antennenvorrichtung 4. Um Wiederholungen zu vermeiden, wird nur der Unterschied beschrieben.

Das erste Substrat 2 weist im Bereich der integrierten Antennenvorrichtung 4 durchgehende Löcher 90 auf. Die Löcher 90 sind dabei vorzugweise periodisch angeordnet. Dies reduziert zum einen die Permittivität des ersten Substrats 2 in diesem Areal. Zum anderen sind die Löcher 90 in einer Ausgestaltung derartig ausgeführt, dass sich beispielsweise eine photonische Bandlückenstruktur ergibt, die dafür genutzt wird, um Oberflächenwellen zu filtern. In einer alternativen - nicht dargestellten - Ausgestaltung sind die Löcher im ersten Substrat 2 des Moduls 1 der Fig. 1 realisiert.

Weiterhin ist hier in dem Bereich des zweiten Substrats 3, der von der integrierten Antennenvorrichtung 4 durchstrahlt wird, Material entfernt worden. Dies geschieht z. B. durch Ätzen. Das zweite Substrat 3 verfügt somit über eine Aussparung oder über eine Lücke. Dies wirkt sich entsprechend auf die Abstrahleigenschaften der integrierten Antennenvorrichtung 4 aus. An die Aussparung angrenzend finden sich zwei Durchkontaktierungen als Abschirmvorrichtungen 7, die die elektronischen Komponenten 5, 6 vor den elektromagnetischen Signalen der integrierten Antennenvorrichtung 4 schützen.

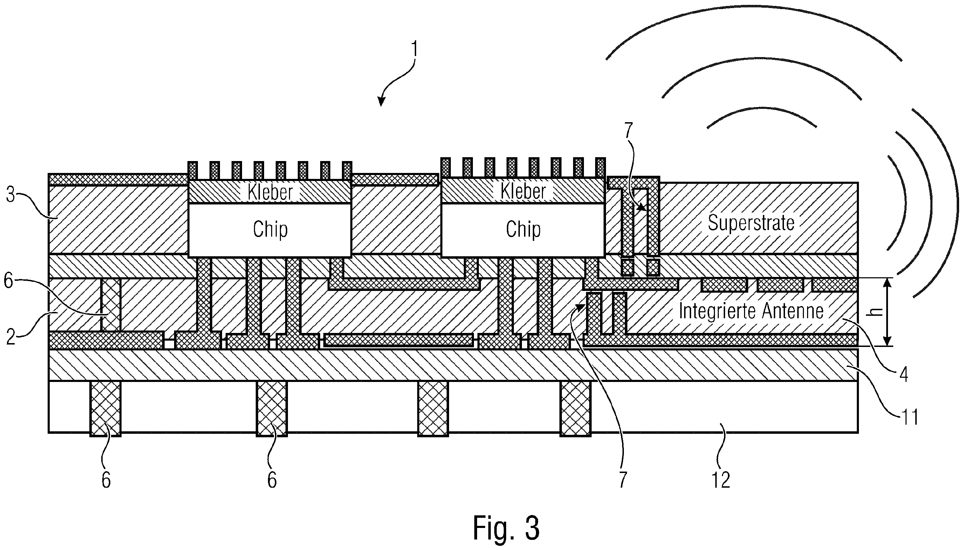

In der Ausgestaltung der Fig. 3 verfügt das elektronische Modul 1 über eine Leiterplattenanordnung mit beispielhaft vier Substraten (dabei wird das zweite Substrat 3 als oberste Lage betrachtet):
- das zweite Substrat 3, durch das die integrierte Antennenvorrichtung 4 abstrahlt,
- das erste Substrat 2, in dem die integrierte Antennenvorrichtung 4 integriert und Komponenten 6 eingebettet sind,
- ein Substrat 11, das einer Rauschunterdrückung dient und z. B. als Metalllage ausgeführt ist, und
- ein zusätzliches Substrat 12 darunter, in dem weitere Komponenten 6 zum Betrieb des Systems des elektronischen Moduls 1 eingebettet sind.

Eine Ausgestaltung des Herstellungsverfahrens umfasst beispielhaft zumindest die folgenden Schritte:
- Auf dem ersten Substrat 2 wird die integrierte Antennenvorrichtung 4 erzeugt. Dabei werden ggf. Löcher 90 eingebracht. Zudem werden auch Aussparungen oder Löcher für elektrische Kontakte oder wärmeübertragende Abschirmvorrichtungen usw. erzeugt. Dabei befindet sich die integrierte Antennenvorrichtung 4 auf einer Seite und befinden sich Anschlusskontakte usw. auf der gegenüberliegenden Seite des ersten Substrats 2. Im ersten Substrat 2 sind in einer Ausgestaltung weitere Komponenten, die für die Realisierung des Systems notwendig sind, eingebettet.
- In das zweite Substrat 3 werden die erforderlichen elektronischen Komponenten, z. B. Integrierte Schaltungen, Chips, passive Bauteile usw. eingebracht. In einer Variante werden die Komponenten in das zweite Substrat 3 eingebettet, so dass sie von dem

Material des zweiten Substrats 3 umgeben sind.
- Auf das zweite Substrat 3 wird das erste Substrat 2 so aufgebracht, dass die integrierte Antennenvorrichtung 4 dem zweiten Substrat 3 zugewandt ist und auf dem zweiten Substrat 3 aufliegt. Die integrierte Antennenvorrichtung 4 befindet sich somit eingebettet zwischen dem ersten Substrat 2 und dem zweiten Substrat 3.
- Dann werden die notwendigen Verbindungen für elektrische und/oder wärmeübertragende Kontaktierungen erzeugt und die beiden Substrate 2, 3 werden miteinander fixiert. Die Verbindungsstrukturen 9a zwischen Komponenten 5, 6 bzw. die Verbindungsstrukturen 9b zwischen elektronischen Komponenten 5, 6 und der integrierten Antennenvorrichtung 4 befinden sich dabei innerhalb des elektronischen Moduls 1 bzw. innerhalb der Leiterplattenanordnung, die aus mindestens zwei Substraten 2, 3 und vorzugweise aus mehreren Substraten 2, 3, 11, 12 gebildet wird. Weitere Kontakte sind auf einer Seite der elektronischen Moduls 1 zusammengeführt, wobei es sich in einer Ausgestaltung insbesondere um die Seite handelt, die der Abstrahlungsrichtung der integrierten Antennenvorrichtung gegenüberliegt.

Obwohl manche Aspekte im Zusammenhang mit einer Vorrichtung beschrieben wurden, versteht es sich, dass diese Aspekte auch eine Beschreibung des entsprechenden Herstellungsverfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Elektronisches Modul (1),
wobei das elektronische Modul (1) ein erstes Substrat (2) und ein zweites Substrat (3) aufweist,
wobei das erste Substrat (2) eine integrierte Antennenvorrichtung (4) trägt, und wobei das erste Substrat (2) mit dem zweiten Substrat (3) verbunden ist, wobei eine Oberseite des ersten Substrats (2) auf einer Unterseite (30) des zweiten Substrats (3) aufliegt,
wobei das zweite Substrat (3) mindestens eine elektronische Komponente (5, 6) trägt, die in dem zweiten Substrat (2, 3, 11, 12) eingebettet ist,
wobei in dem zweiten Substrat (3) neben der mindestens einen elektronischen Komponente (5, 6) auf Seiten der integrierten Antennenvorrichtung (4) mindestens eine Abschirmvorrichtung (7) in Form einer Durchkontaktierung vorhanden ist, die neben der mindestens einen elektronischen Komponente (5, 6) angeordnet ist und die eingebettete Komponente (5, 6) vor den elektromagnetischen Signalen der integrierten Antennenvorrichtung (4) schützt,
**dadurch gekennzeichnet, dass** ein Reflektor (41) der integrierten Antennenvorrichtung (4) auf einer Unterseite (21) des ersten Substrats (2) angeordnet ist, die einer Seite (20) gegenüberliegt, auf der sich die integrierte Antennenvorrichtung (4) im Wesentlichen befindet.

2. Elektronisches Modul (1) nach Anspruch 1,
wobei unterhalb des ersten Substrats (2) weitere Substrate (11, 12) vorhanden sind.

3. Elektronisches Modul (1) nach einem der Ansprüche 1 bis 2,
wobei die integrierte Antennenvorrichtung (4) dazu ausgelegt ist lateral oder vertikal oder lateral und vertikal elektromagnetische Signale abzustrahlen.

4. Elektronisches Modul (1) nach einem der Ansprüche 1 bis 3,
wobei die integrierte Antennenvorrichtung (4) und die elektronischen Komponenten (5, 6) und/oder die elektronischen Komponenten (5, 6) untereinander über Verbindungsstrukturen (9a, 9b) zur Übertragung von elektrischen Signalen und/oder elektrischer Energie miteinander verbunden sind, und
wobei die Verbindungsstrukturen (9a, 9b) innerhalb des elektronischen Moduls (1) angeordnet sind.

5. Elektronisches Modul (1) nach einem der Ansprüche 1 bis 4,
wobei das erste Substrat (2) bis auf die integrierte Antennenvorrichtung (4) frei von elektronischen Komponenten (5, 6) ist.

6. Elektronisches Modul (1) nach einem der Ansprüche 1 bis 5,
wobei die integrierte Antennenvorrichtung (4) derartig auf und/oder in dem ersten Substrat (2) aufgebracht ist und das erste Substrat (2) derartig relativ zu dem zweiten Substrat (3) angeordnet ist, dass eine Hauptabstrahlrichtung der Antennenvorrichtung (4) dem zweiten Substrat (3) zugewandt ist.

7. Elektronisches Modul (1) nach Anspruch 6,
wobei in dem zweiten Substrat (3) mindestens eine Durchkontaktierung (7) zwischen einer Komponente (5, 6) und einem in der Hauptabstrahlrichtung der integrierten Antennenvorrichtung (4) liegenden Bereich vorhanden ist.

8. Elektronisches Modul (1) nach einem der Ansprüche 1 bis 7,
wobei die integrierte Antennenvorrichtung (4) derartig auf und/oder in dem ersten Substrat (2) aufgebracht ist und das erste Substrat (2) derartig relativ zu dem zweiten Substrat (3) angeordnet ist, dass das zweite Substrat (3) oberhalb der integrierten Antennenvorrichtung (4) frei von abschirmenden Komponenten (5, 6) ist.

9. Elektronisches Modul (1) nach einem der Ansprüche 1 bis 8,
wobei das erste Substrat (2) und das zweite Substrat (3) unterschiedliche Dicken aufweisen.

10. Elektronisches Modul (1) nach einem der Ansprüche 1 bis 9,
wobei das erste Substrat (2) und das zweite Substrat (3) zumindest teilweise aus unterschiedlichen Materialien bestehen.

11. Elektronisches Modul (1) nach einem der Ansprüche 1 bis 10,
wobei mindestens ein - vorzugsweise mit einer elektronischen Komponente (5, 6) thermisch leitend kontaktiertes - Kühlelement (8) vorhanden ist.

12. Verfahren zur Herstellung eines elektronischen Moduls (1),
wobei ein erstes Substrat (2) mit einer integrierten Antennenvorrichtung (4) erzeugt wird, und
wobei das erste Substrat (2) auf einem zweiten Substrat (3) aufgebracht wird; wobei eine Oberseite des ersten Substrats (2) auf einer Unterseite (30) des zweiten Substrats (3) aufliegt,
wobei das zweite Substrat (3) mindestens eine elektronische Komponente (5, 6) trägt, die in dem zweiten Substrat (2, 3, 11, 12) eingebettet ist,
wobei neben der mindestens einen elektronischen Komponente (5, 6) auf Seiten der integrierten Antennenvorrichtung (4) mindestens eine Abschirmvorrichtung (7) in Form einer Durchkontaktierung vorhanden ist, die die eingebettete Komponente (5, 6) vor den elektromagnetischen Signalen der integrierten Antennenvorrichtung (4) schützt,
**dadurch gekennzeichnet, dass** ein Reflektor (41) der integrierten Antennenvorrichtung (4) auf einer Unterseite (21) des ersten Substrats (2) angeordnet ist, die einer Seite (20) gegenüberliegt, auf der sich die integrierte Antennenvorrichtung (4) im Wesentlichen befindet.

13. Verfahren nach Anspruch 12,
wobei unterhalb des zweiten Substrats (3) weitere Substrate (11, 12) aufgebracht werden.

14. Verfahren nach Anspruch 12 oder 13,
wobei in das zweite Substrat (3) und/oder in das erste Substrat (2) und/oder in ein weiteres Substrat (11, 12) elektronische Komponenten (5, 6) eingebettet werden.

15. Verfahren nach einem der Ansprüche 12 bis 14,
wobei innerhalb des elektronischen Moduls (1) zwischen der integrierten Antennenvorrichtung (4) und Komponenten (5, 6) und/oder zwischen Komponenten (5, 6) mindestens eine elektrische Verbindungsstruktur (9a, 9b) erzeugt wird.

16. Verfahren nach einem der Ansprüche 12 bis 15,
wobei in einem Bereich des zweiten Substrats (3), der von der integrierten Antennenvorrichtung (4) mit elektromagnetischen Signalen durchstrahlt wird, Material entfernt wird.

17. Verfahren nach einem der Ansprüche 12 bis 16,
wobei in dem ersten Substrat (2) periodisch angeordnete durchgehende Löcher (90) erzeugt werden.

18. Verfahren nach einem der Ansprüche 12 bis 17,
wobei mindestens eine elektronische Komponente (5, 6) mit einem Kühlelement (8) verbunden wird.

19. Elektronisches Modul (1) nach einem der Ansprüche 1 bis 11, wobei das erste und das zweite Substrat (2, 3) separat gefertigt sind, und wobei das erste Substrat (2) nur eine integrierte Antennenvorrichtung (4), elektrische Verbindungen und keine weiteren Komponenten oder elektronischen Bauteile trägt, wobei das zweite Substrat (3) mindestens elektronische Komponenten (5, 6) trägt und wobei das erste Substrat (2) mit dem zweiten Substrat (3) über ein Faser-Matrix-Halbzeug (10) verbunden ist.

## Claims

1. An electronic module (1),
wherein the electronic module (1) comprises a first substrate (2) and a second substrate (3),
wherein the first substrate (2) supports an integrated antenna device (4), and wherein the first substrate (2) is connected to the second substrate (3),
wherein a top side of the first substrate (2) rests on a bottom side (30) of the second substrate (3),
wherein the second substrate (3) supports at least one electronic component (5, 6) embedded in the second substrate (2, 3, 11, 12),
wherein, in the second substrate (3), apart from the at least one electronic component (5, 6), at least one shielding device (7) in the form of a via is present on the side of the integrated antenna device (4), which is arranged next to the at least one electronic component (5, 6) and protects the embedded component (5, 6) from the electromagnetic signals of the integrated antenna device (4),
**characterized in that** a reflector (41) of the integrated antenna device (4) is arranged on a bottom side (21) of the first substrate (2) which is opposite a side (20) on which the integrated antenna device (4) is basically located.

2. The electronic module (1) in accordance with claim 1,
wherein further substrates (11, 12) are present below the first substrate (2).

3. The electronic module (1) in accordance with any of claims 1 to 2,
wherein the integrated antenna device (4) is configured to radiate electromagnetic signals laterally or vertically or laterally and vertically.

4. The electronic module (1) in accordance with any of claims 1 to 3,
wherein the integrated antenna device (4) and the electronic components (5, 6) and/or the electronic components (5, 6), among one another, are connected to one another via connective patterns (9a, 9b) for transmitting electrical signals and/or electrical energy, and
wherein the connective patterns (9a, 9b) are arranged within the electronic module (1).

5. The electronic module (1) in accordance with any of claims 1 to 4,
wherein the first substrate (2) is free from electronic components (5, 6), except for the integrated antenna device (4).

6. The electronic module (1) in accordance with any of claims 1 to 5,
wherein the integrated antenna device (4) is applied on and/or in the first substrate (2) and the first substrate (2) is arranged relative to the second substrate (3) such that a main emission direction of the antenna device (4) faces the second substrate (3).

7. The electronic module (1) in accordance with claim 6,
wherein at least one via (7) is present in the second substrate (3) between a component (5, 6) and a region located in the main emission direction of the integrated antenna device (4).

8. The electronic module (1) in accordance with any of claims 1 to 7,
wherein the integrated antenna device (4) is applied on and/or in the first substrate (2) and the first substrate (2) is arranged relative to the second substrate (3) such that the second substrate (3) is free from shielding components (5, 6) above the integrated antenna device (4).

9. The electronic module (1) in accordance with any of claims 1 to 8,
wherein the first substrate (2) and the second substrate (3) comprise different thicknesses.

10. The electronic module (1) in accordance with any of claims 1 to 9,
wherein the first substrate (2) and the second substrate (3) consist, at least partly, of different materials.

11. The electronic module (1) in accordance with any of claims 1 to 10,
wherein at least one cooling element (8) - preferably contacted to an electronic component (5, 6) in a thermally conducting manner - is present.

12. A method for manufacturing an electronic module (1),
wherein a first substrate (2) comprising an integrated antenna device (4) is produced, and
wherein the first substrate (2) is applied on a second substrate (3);
wherein a top side of the first substrate (2) rests on a bottom side (30) of the second substrate (3),
wherein the second substrate (3) supports at least one electronic component (5, 6) embedded in the second substrate (2, 3, 11, 12),
wherein at least one shielding device (7) in the form of a via is present next to the at least one electronic component (5, 6) on the side of the integrated antenna device (4), the shielding device protecting the embedded component (5, 6) from the electromagnetic signals of the integrated antenna device (4),
**characterized in that** a reflector (51) of the integrated antenna device (4) is arranged on a bottom side (21) of the first substrate (2) which is opposite a side (20) on which the integrated antenna device (4) is basically located.

13. The method in accordance with claim 12,
wherein further substrates (11, 12) are applied below the second substrate (3).

14. The method in accordance with claim 12 or 13,
wherein electronic components (5, 6) are embedded in the second substrate (3) and/or in the first substrate (2) and/or in another substrate (11, 12).

15. The method in accordance with any of claims 12 to 14,
wherein at least one electronic connective pattern (9a, 9b) is produced within the electronic module (1) between the integrated antenna device (4) and components (5, 6) and/or between components (5, 6).

16. The method in accordance with any of claims 12 to 15,
wherein material is removed in a region of the second substrate (3) transmitted by electromagnetic signals from the integrated antenna device (4).

17. The method in accordance with any of claims 12 to 16,
wherein periodically arranged continuous holes (90) are produced in the first substrate (2).

18. The method in accordance with any of claims 12 to 17,
wherein at least one electronic component (5, 6) is connected to a cooling element (8).

19. The electronic module (1) in accordance with any of claims 1 to 11, wherein the first and second substrates (2, 3) are manufactured separately, and wherein the first substrate (2) supports only an integrated antenna device (4), electrical connections and no further components or electronic devices, wherein the second substrate (3) supports at least electronic components (5, 6), and wherein the first substrate (2) is connected to the second substrate (3) via a fiber-matrix semifinished product (10).

## Revendications

1. Module électronique (1),
dans lequel le module électronique (1) présente un premier substrat (2) et un deuxième substrat (3),
dans lequel le premier substrat (2) porte un dispositif d'antenne intégrée (4), et
dans lequel le premier substrat (2) est connecté au deuxième substrat (3),
dans lequel une face supérieure du premier substrat (2) s'appuie sur une face inférieure (30) du deuxième substrat (3),
dans lequel le deuxième substrat (3) porte au moins un composant électronique (5, 6) qui est intégré dans le deuxième substrat (2, 3, 11, 12),
dans lequel est présent, dans le deuxième substrat (3), outre l'au moins un composant électronique (5, 6) du côté du dispositif d'antenne intégrée (4), au moins un dispositif de blindage (7) sous forme d'un via qui est disposé à côté de l'au moins un composant électronique (5, 6) et qui protège le composant intégré (5, 6) contre les signaux électromagnétiques du dispositif d'antenne intégrée (4),
**caractérisé par le fait qu'**un réflecteur (41) du dispositif d'antenne intégrée (4) est disposé sur une face inférieure (21) du premier substrat (2) qui est opposée à une face (20) sur laquelle se trouve substantiellement le dispositif d'antenne intégrée (4).

2. Module électronique (1) selon la revendication 1,
dans lequel d'autres substrats (11, 12) sont présents sous le premier substrat (2).

3. Module électronique (1) selon l'une des revendications 1 à 2,
dans lequel le dispositif d'antenne intégrée (4) est conçu pour rayonner des signaux électromagnétiques latéralement ou verticalement ou latéralement et verticalement.

4. Module électronique (1) selon l'une des revendications 1 à 3, dans lequel le dispositif d'antenne intégrée (4) et les composants électroniques (5, 6) et/ou les composants électroniques (5, 6) entre eux sont connectés les uns aux autres par l'intermédiaire de structures de connexion (9a, 9b) pour la transmission de signaux électriques et/ou d'énergie électrique, et
dans lequel les structures de connexion (9a, 9b) sont disposées à l'intérieur du module électronique (1).

5. Module électronique (1) selon l'une des revendications 1 à 4,
dans lequel le premier substrat (2), à l'exception du dispositif d'antenne intégrée (4), est exempt de composants électroniques (5, 6).

6. Module électronique (1) selon l'une des revendications 1 à 5,
dans lequel le dispositif d'antenne intégrée (4) est placé sur et/ou dans le premier substrat (2) et le premier substrat (2) est disposé par rapport au deuxième substrat (3) de sorte qu'une direction de rayonnement principale du dispositif d'antenne (4) soit orientée vers le deuxième substrat (3).

7. Module électronique (1) selon la revendication 6,
dans lequel est présent, dans le deuxième substrat (3), au moins un via (7) entre un composant (5, 6) et une zone située dans la direction de rayonnement principale du dispositif d'antenne intégrée (4).

8. Module électronique (1) selon l'une des revendications 1 à 7,
dans lequel le dispositif d'antenne intégrée (4) est placé sur et/ou dans le premier substrat (2) et le premier substrat (2) est disposé par rapport au deuxième substrat (3) de sorte que le deuxième substrat (3) au-dessus du dispositif d'antenne intégrée (4) soit exempt de composants de blindage (5, 6).

9. Module électronique (1) selon l'une des revendications 1 à 8,
dans lequel le premier substrat (2) et le deuxième substrat (3) présentent des épaisseurs différentes.

10. Module électronique (1) selon l'une des revendications 1 à 9,
dans lequel le premier substrat (2) et le deuxième substrat (3) sont réalisés au moins partiellement en matériaux différents.

11. Module électronique (1) selon l'une des revendications 1 à 10,
dans lequel est présent au moins un élément de refroidissement (8), de préférence en contact de manière thermo-conductrice avec un composant électronique (5, 6).

12. Procédé de fabrication d'un module électronique (1),
dans lequel est généré un premier substrat (2) avec un dispositif d'antenne intégrée (4), et
dans lequel le premier substrat (2) est placé sur un deuxième substrat (3);
dans lequel une face supérieure du premier substrat (2) s'appuie sur une face inférieure (30) du deuxième substrat (3),
dans lequel le deuxième substrat (3) porte au moins un composant électronique (5, 6) qui est intégré dans le deuxième substrat (2, 3, 11, 12),
dans lequel est présent, outre l'au moins un composant électronique (5, 6) du côté du dispositif d'antenne intégrée (4), au moins un dispositif de blindage (7) sous forme d'un via qui protège le composant intégré (5, 6) contre les signaux électromagnétiques du dispositif d'antenne intégrée (4), **caractérisé par le fait qu'**un réflecteur (41) du dispositif d'antenne intégrée (4) est disposé sur une face inférieure (21) du premier substrat (2) qui est opposée à une face (20) sur laquelle se trouve substantiellement le dispositif d'antenne intégrée (4).

13. Procédé selon la revendication 12,
dans lequel d'autres substrats (11, 12) sont placés au-dessous du deuxième substrat (3).

14. Procédé selon la revendication 12 ou 13,
dans lequel des composants électroniques (5, 6) sont intégrés dans le deuxième substrat (3) et/ou dans le premier substrat (2) et/ou dans un autre substrat (11, 12).

15. Procédé selon l'une des revendications 12 à 14,
dans lequel à l'intérieur du module électronique (1) est générée, entre le dispositif d'antenne intégrée (4) et les composants (5, 6) et/ou entre les composants (5, 6), au moins une structure de connexion électrique (9a, 9b).

16. Procédé selon l'une des revendications 12 à 15,
dans lequel du matériau est enlevé dans une zone du deuxième substrat (3) qui est irradiée par des signaux électromagnétiques par le dispositif d'antenne intégrée (4).

17. Procédé selon l'une des revendications 12 à 16,
dans lequel sont générés, dans le premier substrat (2), des trous traversants (90) disposés périodiquement.

18. Procédé selon l'une des revendications 12 à 17,
dans lequel au moins un composant électronique (5, 6) est connecté à un élément de refroidissement (8).

19. Module électronique (1) selon l'une des revendications 1 à 11, dans lequel le premier et le deuxième substrat (2, 3) sont réalisés séparément, et dans lequel le premier substrat (2) porte uniquement un dispositif d'antenne intégrée (4), des connexions électriques et pas d'autres composants ou composants électroniques, dans lequel le deuxième substrat (3) porte au moins des composants électroniques (5, 6) et dans lequel le premier substrat (2) est connecté au deuxième substrat (3) par l'intermédiaire d'un produit semi-fini à matrice de fibres (10).
